# EUROPÄISCHE PATENTSCHRIFT

(11) **EP 0 582 217 B1**
(45) Veröffentlichungstag und Bekanntmachung des Hinweises auf die Patenterteilung: **29.11.1995**
(21) Anmeldenummer: 93112151.1
(22) Anmeldetag: 29.07.1993
(51) Int. Cl.: H05K 7/20

(54) **Kühlflüssigkeitsgekühltes Stromrichtermodul mit einer durch eine Kühlmittelpumpe erzeugten Kühlflüssigkeitsströmung**
Liquid-cooled current rectifier module with a coolant flow generated by a coolant pump
Module redresseur de courant refroidi par liquide avec un courant de refroidissement obtenu par une pompe de refroidissement

(30) Priorität: 04.08.1992 DE 4225676
(43) Veröffentlichungstag der Anmeldung: 09.02.1994
(73) Patentinhaber: ABB PATENT GmbH, 68309 Mannheim (DE)
(72) Erfinder: Krämer, Wilhelm, D-69207 Sandhausen (DE)
(74) Vertreter: Rupprecht, Klaus, Dipl.-Ing.

(56) Entgegenhaltungen:
- EP-A- 0 446 836
- US-A- 4 885 488
- PATENT ABSTRACTS OF JAPAN, Bd. 006, Nr. 062 (P-111)21. April 1982;& JP-57 005 124

## Beschreibung

Die Erfindung bezieht sich auf ein kühlflüssigkeitsgekühltes Stromrichtermodul mit einer durch eine Kühlmittelpumpe erzeugten Kühlflüssigkeitsströmung gemäß dem Oberbegriff des Anspruchs 1 und kann insbesondere bei stromrichtergespeisten Schienenfahrzeugen eingesetzt werden.

Es sind allgemein sowohl kühlflüssigkeitsgekühlte Stromrichtermodule als auch luftgekühlte Stromrichtermodule bekannt. Ein mittels Isolieröl gekühltes Stromrichtermodul mit externer Kühlmittelpumpe und externem Rückkühler ist beispielsweise aus der DE-A-40 08 425 bekannt.

Bei Einsatz von elektrisch leitfähigem Brauchwasser als Kühlflüssigkeit ist es insbesondere aus Gründen der elektrischen Isolation und des hieraus resultierenden Aufwandes vorteihaft, lediglich die Leistungsbauelemente des Stromrichtermoduls, wie Thyristoren, Dioden, Drosseln und Widerstände durch die Kühlflüssigkeit zu kühlen, während die thermisch gering belasteten Bauelemente, wie Gate-Unit und Stromschienen, vielfach ungekühlt bleiben oder mittels eines eigenen, elektrisch angetriebenen Lüfters gekühlt werden. Der Einsatz eines elektrisch angetriebenen Lüfters ist umständlich, energieaufwendig und nicht wartungsfrei. Es besteht die Gefahr eines Ausfalls durch einen Motordefekt. Deshalb werden elektrische Lüfter vielfach redundant ausgelegt und/oder werden überwacht.

Der Erfindung liegt die Aufgabe zugrunde, ein kühlflüssigkeitsgekühltes Stromrichtermodul mit einer durch eine Kühlmittelpumpe erzeugten Kühlflüssigkeitsströmung anzugeben, bei dem bei Einsatz einer elektrisch leitfähigen Kühlflüssigkeit auch die thermisch gering belasteten Baukomponenten ausreichend gekühlt werden.

Diese Aufgabe wird in Verbindung mit den Merkmalen des Oberbegriffs erfindungsgemäß durch die im Kennzeichen des Anspruchs 1 angegebenen Merkmale gelöst.

Die mit der Erfindung erzielbaren Vorteile bestehen insbesondere darin, daß der vorgeschlagene Kühlflüssigkeitsantrieb für die Stromrichtermodullüftung einfach aufgebaut, energiesparend und wartungsfrei ist. Außer einem Kühlflüssigkeits-Grenzwertgeber sind keinerlei Überwachungen notwendig. Der vorgeschlagene Lüfterantrieb verursacht selbst keine zusätzlichen Wärmeverluste. Aufgrund der relativ niedrigen Temperaturen aller Baukomponenten des Stromrichtermoduls ergibt sich eine erhöhte Betriebssicherheit.

Bei Einsatz von verschleißlosen Lagern - sowohl für das Wasserrad als auch für den Stromrichtermodul-Lüfter - ist die Lebensdauer der Anordnung fast unbegrenzt. Vorteilhaft sind keine hydraulisch abzudichtenden, verschleißbehafteten Drehachsen-Durchführungen erforderlich. Die relativ geringe Drehzahl des Wasserrades wird durch entsprechend groß gestaltete Lüfterflügel ausgeglichen, so daß die erzielte Kühlluftströmung zur Kühlung der thermisch gering belasteten Baukomponenten ausreicht. Dabei bereitet die elektrische Isolation der vielfach mit erhöhtem elektrischem Potential behafteten, thermisch gering belasteten Baukomponenten keinerlei Probleme, da Kühlluft - im Unterschied zu elektrisch leitfähigem Brauchwasser - die elektrische Isolationsfestigkeit gewährleistet. Darüberhinaus ist es vorteilhaft möglich, das Gehäuseinnere des Stromrichtermoduls hermetisch abzuschließen, wodurch negative äußere Beeinflussungen, wie Schmutz, Staub und Feuchtigkeit, zuverlässig vermieden werden. Die Rückkühlung des Stromrichtermodulgehäuses kann beispielsweise durch entsprechende Verrippung der Gehäuseoberfläche in ausreichendem Umfang sichergestellt werden.

Vorteilhafte Ausgestaltungen der Erfindung sind in den Unteransprüchen gekennzeichnet.

Die Erfindung wird nachstehend anhand der in der Zeichnung dargestellten Ausführungsformen erläutert. Es zeigen:
- Figur 1: einen seitlichen Schnitt durch den Antrieb für einen Stromrichtermodul-Lüfter,
- Figur 2: einen Schnitt durch eine alternative Wasserrad-Ausgestaltung.

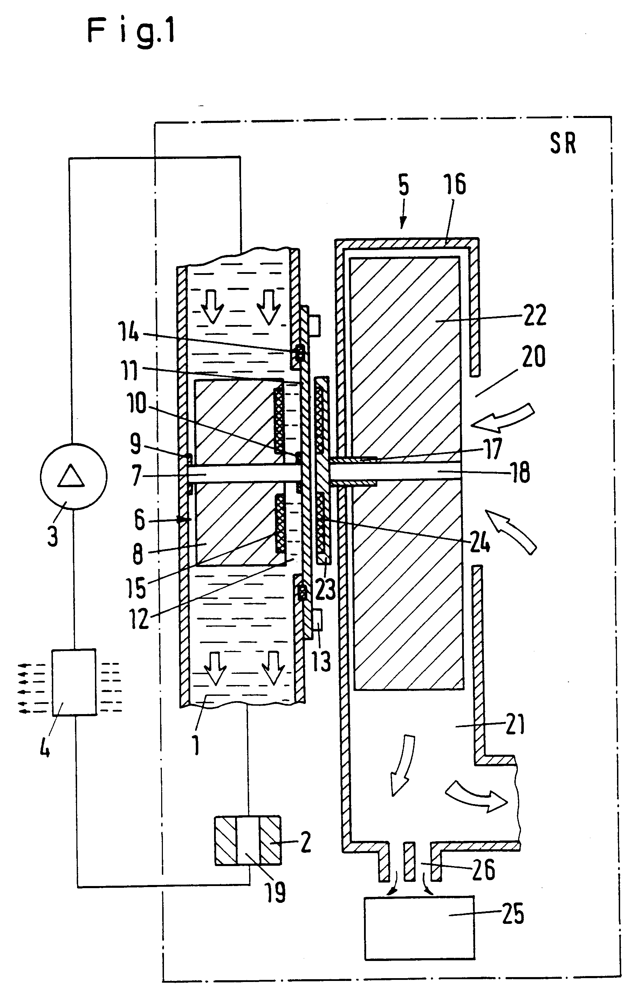

In Figur 1 ist ein seitlicher Schnitt durch den Antrieb für einen Stromrichtermodul-Lüfter dargestellt. Es ist ein innerhalb eines Stromrichtermoduls SR befindlicher Kühlrahmen 1 zu erkennen, in dem eine elektrisch leitfähige Kühlflüssigkeit - vorzugsweise Brauchwasser - zur Kühlung von Leistungsbauelementen 2 eines Stromrichtermoduls - wie Thyristoren, Dioden, Drosseln und Widerständen - zirkuliert. In der Zeichnung ist hierzu beispielhaft und schematisch ein Kühlkörper 19 zur Kühlung von Leistungsthyristoren angedeutet. Die Kühlflüssigkeitsströmung innerhalb des Kühlrahmens 1 wird unter Einsatz einer schematisch gezeigten Kühlmittelpumpe 3 erzeugt. Die von den Leistungsbauelementen 2 abgegebene und von der Kühlflüssigkeit aufgenommene Wärmeenergie wird über einen schematisch gezeigten externen Rückkühler 4 (Luft/Brauchwasser-Kühler) an die Außenatmosphäre abgegeben.

Die Kühlflüssigkeitsströmung innerhalb des Kühlrahmens 1 wird vorteilhaft für den Antrieb eines Stromrichtermodul-Lüfters 5 ausgenutzt. Hierzu befindet sich ein Wasserrad 6 innerhalb des Kühlrahmens 1. Das aus mehreren mit einer Welle 7 verbundenen Schaufeln 8 (beispielsweise aus Polyamid) bestehende Wasserrad ist in Lagern 9, 10 - vorzugsweise vom Flüssigkeitsstrom umspülte, radial und axial selbstschmierende Kunststofflager - verschleißlos gelagert. Lager 9 ist an der Innenwandung des Kühlrahmens 1 befestigt, während sich Lager 10 auf einer relativ dünnwandigen Verschlußplatte 11 befindet.

Die Verschlußplatte 11 dient zur Abdeckung einer Öffnung 12 des Kühlrahmens 1 und ist mittels Schrauben 13 am Kühlrahmen 1 befestigt, wobei eine zwischen Kühlrahmen 1 und Verschlußplatte 11 eingelegte Dichtung 14 die hydraulische Abdichtung gewährleistet. Die aus einem amagnetischen Material bestehende Verschlußplatte 11 ermöglicht insbesondere den Einbau des Wasserrades 6 in den Kühlrahmen 1 und gewährleistet eine einfache Zugänglichkeit.

In den Schaufeln 8 des Wasserrades 6 sind Dauermagnete 15 eingebettet, und zwar in unmittelbarer Nähe der Verschlußplatte 11. Ebenfalls in unmittelbarer Nähe der Verschlußplatte 11, jedoch außerhalb des Kühlrahmens 1, ist ein Lüftergehäuse 16 angeordnet. Das Lüftergehäuse 16 weist ein Lager 17 zur Lagerung der Welle 18 des Stromrichtermodul-Lüfters 5, eine Lufteintrittsöffnung 20 sowie einen Luftaustrittskanal 21 auf. Lager 17 ist vorzugsweise ein verschleißloses, radial und axial selbstschmierendes Trokkenlauflager.

Der Antrieb des auf der Welle 18 sitzenden, relativ großen Lüfterflügels 22 erfolgt mittels magnetischer Kopplung. Hierzu sind in einer außerhalb des Lüftergehäuses 16 auf der Welle 18 montierten Scheibe 23 mehrere Dauermagnete 24 eingebettet. Die Achsen der Wellen 7 und 18 sind deckungsgleich und die Dauermagnete 15 und 24 liegen sich direkt gegenüber, lediglich getrennt durch eine geringe Kühlflüssigkeitsstrecke, durch die amagnetische Verschlußplatte 11 und eine geringe Luftstrecke.

Bei Rotation des Wasserrades 6 durch die Kühlflüssigkeitsströmung ergibt sich somit infolge magnetischer Kopplung über die Dauermagnete 15 und 24 eine Rotation der Lüfterflügel 22. Die rotierenden Lüfterflügel 22 saugen Luft aus dem Gehäuseinneren des Stromrichtermoduls SR an, wodurch eine Luftströmung durch den Luftaustrittskanal 21 erzeugt wird. Diese Luftströmung wird gezielt auf thermisch gering belastete Baukomponenten 25 im Gehäuseinneren des Stromrichtermoduls, wie beispielsweise Gate-Unit, Stromschienen usw. gerichtet. Hierzu ist der Luftaustrittskanal 21 beispielsweise mit Ausströmern 26 versehen.

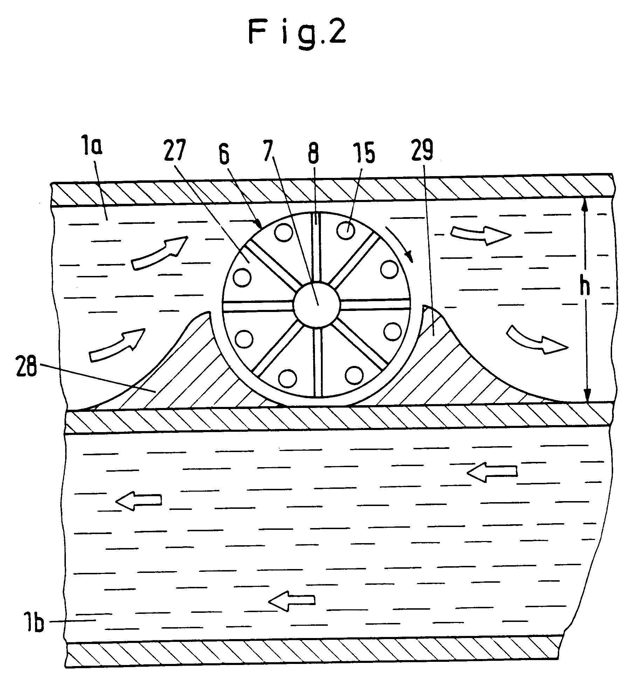

In Figur 2 ist ein Schnitt durch eine alternative Wasserrad-Ausgestaltung dargestellt. Es ist das im Kühlflüssigkeitsvorlaufkanal 1a des Kühlrahmens 1 befindliche Wasserrad 6 mit Schaufeln 8, Dauermagneten 15 und Welle 17 zu erkennen. Die Dauermagnete 15 werden in Seitenscheiben 27 fixiert. Zur Erzielung eines gewünschten Drehmomentes am Wasserrad und einer erhöhten Kühlflüssigkeits-Strömungsgeschwindigkeit ist die innere Höhe h des Kühlflüssigkeitsvorlaufkanals 1a etwa zur Hälfte mittels Strömungsfüllstücken 28, 29 derart reduziert, daß ungefähr die Hälfte des Wasserrades abgedeckt ist. Die im Hinblick auf möglichst geringe Reibungsverluste gestalteten Füllstücken 28, 29 verengen den Strömungsquerschnitt auf die Hälfte, wodurch sich die Strömungsgeschwindigkeit der Kühlflüssigkeit verdoppelt. Der Kühlflüssigkeitsrücklaufkanal ist mit 1b bezeichnet.

## Patentansprüche

1. Kühlflüssigkeitsgekühltes Stromrichtermodul mit einer durch eine Kühlmittelpumpe (3) erzeugten Kühlflüssigkeitsströmung zur Kühlung von Leistungsbauelementen (2) des Stromrichtermoduls (SR), wie Thyristoren, Dioden, Drosselspulen und Widerständen, dadurch gekennzeichnet, daß die Kühlflüssigkeitsströmung für den Antrieb eines Stromrichtermodul-Lüfters (5) herangezogen wird, der zur Luftkühlung von thermisch gering belasteten Baukomponenten (25) im Gehäuseinneren des Stromrichtermoduls (SR) dient.

2. Stromrichtermodul nach Anspruch 1, dadurch gekennzeichnet, daß in einem die Kühlflüssigkeitsströmung führenden Kühlrahmen (1) ein Wasserrad (6) vorgesehen ist, daß der Stromrichtermodul-Lüfter (5) unmittelbar gegenüber dem Wasserrad (6) angeordnet ist, daß die Lagerachsen bzw. Wellenachsen des Wasserrades (6) und des Stromrichtermodul-Lüfters (5) deckungsgleich sind und daß die Schaufeln (8) des Wasserrades (6) mit Dauermagneten (15) versehen sind.

3. Stromrichtermodul nach Anspruch 2, dadurch gekennzeichnet, daß der Stromrichtermodul-Lüfter (5) ebenfalls mit Dauermagneten (24) versehen ist, welche unmittelbar gegenüber den Dauermagneten (15) des Wasserrades (6) angeordnet sind und mit den Lüfterflügeln (22) in mechanischer Verbindung stehen.

4. Stromrichtermodul nach Anspruch 3, dadurch gekennzeichnet, daß sich die Dauermagnete (24) des Stromrichtermodul-Lüfters (5) auf einer außerhalb des Lüftergehäuses (16) angeordneten, mit der Lüfterwelle (18) verbundenen Scheibe (23) befinden.

5. Stromrichtermodul nach wenigstens einem der Ansprüche 1 bis 4, dadurch gekennzeichnet, daß der Kühlrahmen (1) zur Montage des Wasserrades (6) mit einer Öffnung (12) versehen ist, welche mit einer abnehmbaren Verschlußplatte (11) abgedeckt ist.

6. Stromrichtermodul nach Anspruch 5, dadurch gekennzeichnet, daß die Welle (7) des Wasserrades (6) in verschleißfreien Lagern (9,10) gelagert ist, welche sich an der Innenwandung des Kühlrahmens (1) und der Verschlußplatte (11) befinden.

7. Stromrichtermodul nach wenigstens einem der Ansprüche 1 bis 6, dadurch gekennzeichnet, daß die Lüfterwelle (18) in einem verschleißfreien Lager (17) gelagert ist.

8. Stromrichtermodul nach wenigstens einem der Ansprüche 1 bis 7, dadurch gekennzeichnet, daß das Lüftergehäuse (16) neben einer Lufteintrittsöffnung (20) einen Luftaustrittskanal (21) aufweist, der zur gezielten Luftzuführung zu den Baukomponenten (25) dient.

9. Stromrichtermodul nach Anspruch 8, dadurch gekennzeichnet, daß der Luftaustrittskanal (21) mit Ausströmern (26) versehen ist.

10. Stromrichtermodul nach wenigstens einem der Ansprüche 2 bis 9, dadurch gekennzeichnet, daß der Strömungsquerschnitt des Kühlrahmens 1 in unmittelbarer Nähe des Wasserrades (6) verengt ist, wobei das Wasserrad vorzugsweise zur Hälfte mit Strömungsfüllstücken (28,29) abgedeckt ist.

## Claims

1. Liquid-coolant-cooled converter module with a liquid-coolant flow produced by a coolant pump (3) for the purpose of cooling power components (2) of the converter module (SR), such as thyristors, diodes, inductors and resistors, characterized in that the liquid-coolant flow is used for the drive of a converter module fan (5) which is used for the air cooling of structural components (25) which are thermally loaded to a small extent in the housing interior of the converter module (SR).

2. Converter module according to Claim 1, characterized in that a water-wheel (6) is provided in a cold frame (1) which guides the liquid-coolant flow, in that the converter module fan (5) is arranged directly opposite the water-wheel (6), in that the bearing axes or shaft axes of the water-wheel (6) and of the converter module fan (5) are congruent, and in that the paddles (8) of the water-wheel (6) are provided with permanent magnets (15).

3. Converter module according to Claim 2, characterized in that the converter module fan (5) is likewise provided with permanent magnets (24) which are arranged directly opposite the permanent magnets (15) of the water-wheel (6) and are mechanically connected to the fan blades (22).

4. Converter module according to Claim 3, characterized in that the permanent magnets (24) of the converter module fan (5) are situated on a disc (23) which is arranged outside the fan housing (16) and is connected to the fan shaft (18).

5. Converter module according to at least one of Claims 1 to 4, characterized in that the cold frame (1) is provided with an opening (12) for installing the water-wheel (6), which opening is covered by a removable closure plate (11).

6. Converter module according to Claim 5, characterized in that the shaft (7) of the water-wheel (6) is supported in wear-free bearings (9, 10) which are situated on the inner wall of the cold frame (1) and on the closure plate (11).

7. Converter module according to at least one of Claims 1 to 6, characterized in that the fan shaft (18) is supported in a wear-free bearing (17).

8. Converter module according to at least one of Claims 1 to 7, characterized in that in addition to an air inlet opening (20) the fan housing (16) has an air outlet channel (21), which is used for the specific feeding of air to the structural components (25).

9. Converter module according to Claim 8, characterized in that the air outlet channel (21) is provided with dischargers (26).

10. Converter module according to at least one of Claims 2 to 9, characterized in that the flow cross-section of the cold frame 1 is constricted in the direct vicinity of the water-wheel (6), preferably up to half of the water-wheel being covered by flow filling elements (28, 29).

## Revendications

1. Module convertisseur de courant refroidi par liquide avec un courant de liquide de refroidissement produit par une pompe de refroidissement pour refroidir des composants de puissance (2) du module convertisseur de courant (SR), tels que des thyristors, diodes, bobines d'inductance et résistances, caractérisé par le fait que le courant de liquide de refroidissement est utilisé pour l'entraînement d'un ventilateur de module convertisseur de courant (5), qui sert au refroidissement par air de composants (25) faiblement sollicités thermiquement, à l'intérieur de l'enceinte du module convertisseur de courant (SR).

2. Module convertisseur de courant suivant la revendication 1, caractérisé par le fait qu'une roue à eau (6) est prévue dans un cadre de refroidissement (1) conduisant le courant de liquide de refroidissement, que le ventilateur de module convertisseur de courant (5) est disposé directement en face de la roue à eau (6), que les axes des paliers ou arbres de la roue à eau (6) et du ventilateur de module convertisseur de courant (5) sont alignés et que les aubes (8) de la roue à eau (6) sont munies d'aimants permanents (15).

3. Module convertisseur de courant suivant la revendication 2, caractérisé par le fait que le ventilateur de module de convertisseur de courant (5) est également muni d'aimants permanents (24) qui sont disposés directement en face des aimants permanents (15) de la roue à eau (6) et se trouvent en liaison mécanique avec les pales de ventilateur (22).

4. Module convertisseur de courant suivant la revendication 3, caractérisé par le fait que les aimants permanents (24) du ventilateur de module convertisseur de courant (5) se trouvent sur un disque (23) relié à l'arbre de ventilateur (18) et disposé à l'extérieur du carter de ventilateur (16).

5. Module convertisseur de courant suivant au moins l'une des revendications 1 à 4, caractérisé par le fait que le cadre de refroidissement (1) comporte, en vue du montage de la roue à eau (6), une ouverture (12) recouverte par une plaque de fermeture (11) amovible.

6. Module convertisseur de courant suivant la revendication 5, caractérisé par le fait que l'arbre (7) de la roue à eau (6) est monté dans des paliers anti-usure (9,10) qui se trouvent sur la paroi intérieure du cadre de refroidissement (1) et de la plaque de fermeture (11).

7. Module convertisseur de courant suivant au moins l'une des revendications 1 à 6, caractérisé par le fait que l'arbre de ventilateur (18) est monté dans un palier anti-usure (17).

8. Module convertisseur de courant suivant au moins l'une des revendications 1 à 7, caractérisé par le fait que le carter de ventilateur (16) présente, outre une ouverture d'entrée d'air (20), un canal de sortie d'air (21) servant au guidage de l'air vers les composants (25).

9. Module convertisseur de courant suivant la revendication 8, caractérisé par le fait que le canal de sortie d'air (21) est muni de buses de soufflage (26).

10. Module convertisseur de courant suivant au moins l'une des revendications 2 à 9, caractérisé par le fait que la section d'écoulement du cadre de refroidissement (1) est réduite à proximité immédiate de la roue à eau (6), la roue à eau étant recouverte de préférence à moitié par des pièces de remplissage (28,29).
